# EUROPEAN PATENT APPLICATION

(11) **EP 2 485 569 A1**
(43) Date of publication of application: **08.08.2012**
(21) Application number: 10820616.0
(22) Date of filing: 22.09.2010
(51) Int. Cl.: H05B 33/26, H01L 51/50, H05B 33/12, H05B 33/22

(54) **ORGANIC EL DEVICE**

(30) Priority: 29.09.2009 JP 2009225295
(71) Applicant: Sumitomo Chemical Co., Ltd, Chuo-ku, Tokyo 104-8260 (JP)
(72) Inventor: KASAHARA, Kenji, Niihama-shi Ehime 792-0009 (JP); SHIMIZU, Masaya, Niihama-shi Ehime 792-0009 (JP)
(74) Representative: Jackson, Martin Peter
(86) International application number: PCT/JP2010/067014
(87) International publication number: WO 2011/040501

(57) **Abstract**

The present invention provides an organic EL device. The organic EL device is provided with a first substrate, an anode that is located on the first substrate, a light emitting layer that is located on the anode, a partition wall that is formed of an insulating material and partitions the light emitting layer, a cathode that covers the light emitting layer and extends on the partition wall, and a second substrate that is superimposed onto the first substrate via a seal member, and in this structure, the cathode has a multilayer structure including an electron injection layer that injects electrons to the light emitting layer, and at least one electrically conductive layer, and the electron injection layer covers the light emitting layer, and the at least one electrically conductive layer covers the electron injection layer.

## Description

### TECHNICAL FIELD

The invention relates to an organic EL device provided with an organic electroluminescence (hereinafter, referred to as "organic EL") element.

### BACKGROUND ART

An organic EL device provided with an organic EL element has already been put into practical use as a device for use in portable telephones and the like. The organic EL element is a laminated product having an anode and a cathode and one or more organic EL layers including a light emitting layer sandwiched between these electrodes. The light emitting layer is made of an organic compound that emits light when, upon application of a voltage thereto, a current flows therethrough. The organic EL element has various characteristics. The organic EL element is formed by stacking thin films. By using the organic EL element, an apparatus such as a light-emitting apparatus can be made into an extremely thin form.

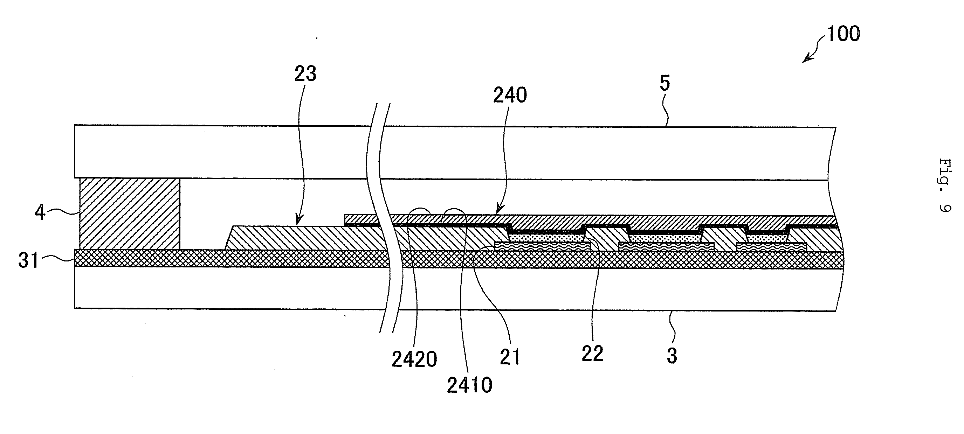

Referring to Fig. 9, the following description will discuss a conventional organic EL device.

A conventional organic EL device shown in Fig. 9 is provided with a first substrate 3 having a rectangular shape, an anode 21 placed on the first substrate 3, a circuit layer (not shown) that includes wiring, a light emitting layer 22 disposed on the circuit layer and the anode 21 in a dot-matrix pattern, partition walls 23 disposed between the light emitting layers 22 as well as on the periphery of the light emitting layer 22, a cathode 240 that is placed on the light emitting layer 22 and the partition walls 23, and a second substrate 5 that is superimposed on the first substrate 3 with a seal member 4 interpolated therebetween.

Patent Document 1 has disclosed another conventional organic EL device.

The light emitting apparatus disclosed in Patent Document 1 is provided with a plurality of OLEDs (Organic Light Emitting Diodes) disposed on a substrate, each of which has a light emitting layer and an anode and a cathode that sandwich the light emitting layer, an insulating film that insulates the anodes and cathodes of the plurality of OLEDs from each other, a peripheral wall positioned outside of the insulating film, and a sealing layer that covers the plurality of OLEDs and the insulating film. The sealing layer of the light emitting apparatus is constituted by one layer or a plurality of layers of thin films. Between the insulating film and the peripheral wall, an end of a thin film (an organic buffer film or a gas barrier layer) which has the largest film thickness among those of the thin films forming the sealing layer is located.

### PRIOR ART DOCUMENTS

### PATENT DOCUMENT

[Patent Document 1]: JP2008-311239A

### DISCLOSURE OF THE INVENTION

In the conventional organic EL device shown in Fig. 9, upon forming an electron injection layer 2410 and an electrically conductive layer 2420 that form a cathode 240, the same mask is used. Therefore, the end of the electron injection layer 2410 and the end of the electrically conductive layer 2420 are disposed at the same position where the end face of the electron injection layer 2410 is exposed.

The inner space between the first substrate 3 and the second substrate 5 is filled with an inert gas, or filled with a sealing resin. However, moisture tends to enter the inner space little by little via the seal member 4, and reach the light emitting layer 22 after passing through a gap between the electron injection layer 2410 and the partition wall 23 as well as between the electron injection layer 2410 and the electrically conductive layer 2420. The organic compound forming the light emitting layer 22 is fragile to moisture and easily deteriorates, and when moisture has reached the light emitting layer 22, a reduction in luminescence is caused in the organic EL device.

In the light emitting apparatus of Patent Document 1, the sealing layer formed by one layer or a plurality of layers of thin films is disposed on the cathode layer formed by vapor-depositing an electrically conductive material, in a manner so as to cover the cathode layer. However, a sealing layer needs to be newly disposed on the cathode layer. Consequently, a film-forming process for forming the sealing layer is required to cause high production costs.

In the light emitting apparatus described in Patent Document 1, the cathode layer is illustrated and explained as one layer; however, a description is given such that a plurality of layers may be used. However, with respect to the structure having a plurality of layers of cathodes, neither specific description is given, nor problems of moisture invasion via the cathode are described.

In Patent Document 1, if, by omitting the sealing layer, the cathode layer was used as the surface layer of the laminated product, with the electron injection layer and the electrically conductive layer being formed by using the same mask, and if the cathode layer was disposed in a manner so as to cover the insulating film (partition walls), the end face of the electron injection layer would be exposed, with the result that moisture would enter the inner space to reach the light emitting layer, in the same manner as in the conventional organic EL device as shown in Fig. 9.

The objective of the present invention is to provide an organic EL device in which moisture invasion into the light emitting layer is suppressed.

An organic EL device of the present invention is provided with a first substrate, an anode that is located on the first substrate, a light emitting layer that is located on the anode, a partition wall that is formed of an insulating material and partitions the light emitting layer, a cathode that covers the light emitting layer and extends on the partition wall, and a second substrate that is superimposed to the first substrate via a seal member, and in this structure, the cathode has a multilayer structure including an electron injection layer that injects electrons to the light emitting layer, and at least one electrically conductive layer, and the electron injection layer covers the light emitting layer, and the at least one electrically conductive layer covers the electron injection layer.

In the present invention, the cathode that covers the light emitting layer and extends on the partition wall is constituted by an electron injection layer and an electrically conductive layer. Since the electron injection layer covers the light emitting layer and since the electrically conductive layer covers the electron injection layer, it is possible to prevent moisture from invading therein through a gap between the electron injection layer and the partition wall as well as a gap between the electron injection layer and the electrically conductive layer. In this case, the term "extends" means an extended state from the light emitting layer to the partition wall.

The electrically conductive layer preferably covers the partition wall. Even in the case when the partition wall is made of a material through which moisture permeates, since the electrically conductive layer covers the partition wall, it is possible to further suppress the moisture invasion into the light emitting layer.

The electron injection layer preferably covers the partition wall. With this structure, even in the case of an electron injection layer prepared as a thin film, it is possible to further suppress the moisture invasion into the light emitting layer.

The electrically conductive layer is preferably composed of a first electrically conductive layer disposed on the electron injection layer and a second electrically conductive layer that covers the first electrically conductive layer. With this structure, it is possible to suppress a layer separation due to oxidization of its electron injection layer.

The second electrically conductive layer preferably covers the partition wall. With this structure, it is possible to further suppress the moisture invasion into the light emitting layer.

The first electrically conductive layer and the second electrically conductive layer may be made of the same electrically conductive material. The first electrically conductive layer and the second electrically conductive layer may be respectively made of a first electrically conductive material and a second electrically conductive material that is different from the first electrically conductive material. By forming the first electrically conductive layer and the second electrically conductive layer by using respectively different electrically conductive materials, the range of selection of electrically conductive materials is widened. As the first electrically conductive material, electrically conductive materials such as Al and Ag that can be formed into a film by using a film forming method that hardly gives damages to the light emitting layer, such as a low resistivity heating vapor deposition method, a cell heating vapor deposition method and an electron-beam vapor deposition method can be selected. As the second electrically conductive material, electrically conductive materials such as Al, Ag, Cu, ITO (indium tin oxide), IZO (indium zinc oxide), etc. that can be formed into a film by using a method capable of accelerating a film-forming rate, such as an electron beam vapor deposition method, a high-frequency inductive heating vapor deposition method, a sputtering method and an ion plating method, can be selected. With this arrangement, it is possible to accelerate the processing speed of the entire cathode-forming processes while suppressing degradation of characteristics of the light emitting layer. From the viewpoint of adhesion to the frame edge portion of the partition wall, Al, Ag and Cu are desirably used as the second electrically conductive material.

Examples of the first electrically conductive material include a metal selected from the group consisting of Al, Cu and Ag, an alloy containing one kind of these metals as a main component, an indium tin oxide (ITO), and an indium zinc oxide (IZO). Examples of the second electrically conductive material include a metal selected from the group consisting of Al, Cu and Ag, an alloy containing one kind of these metals as a main component, an indium tin oxide (ITO), and an indium zinc oxide (IZO). By appropriately selecting these electrically conductive materials, it is possible to consequently improve a luminance reduction rate of the organic EL device.

In the case when the first electrically conductive layer and the second electrically conductive layer are made of the same electrically conductive material, the electrically conductive layer has an area composed of only the second electrically conductive layer and an area composed of the first electrically conductive layer and the second electrically conductive layer, that is, areas being different in film thickness from each other are prepared. With this arrangement, the presences of the first electrically conductive layer and the second electrically conductive layer can be confirmed.

The electron injection layer and the first electrically conductive layer preferably have the same pattern. Thus, upon forming the electron injection layer and the first electrically conductive layer by a vacuum vapor deposition method, these can be formed by using the same mask. Consequently, the electron injection layer and the first electrically conductive layer can be easily formed.

### BRIEF DESCRIPTION OF THE DRAWINGS

Fig. 1 shows a plan view illustrating an organic EL device in accordance with embodiment 1 of the present invention.
Fig. 2 shows an A-A line cross-sectional view of the organic EL device of Fig. 1.
Fig. 3 shows a drawing that explains a circuit configuration of the organic EL device of Fig. 1.
Fig. 4 shows a cross-sectional view that explains a state of use of the organic EL device of Fig. 1.
Fig. 5 shows a plan view that illustrates an organic EL device in accordance with embodiment 2 of the present invention.
Fig. 6 shows a B-B line cross-sectional view of the organic EL device of Fig. 5.
Fig. 7 shows a plan view that illustrates an organic EL device in accordance with embodiment 3 of the present invention.
Fig. 8 shows a C-C line cross-sectional view of the organic EL device of Fig. 7.
Fig. 9 shows a partial cross-sectional view that illustrates a conventional organic EL device.

### EXPLANATION OF REFERENCE NUMERALS

- 1, 10x, 10y: Organic EL device
- 2: Pixel circuit
- 21: Anode
- 22: Light emitting layer
- 23: Partition wall
- 23a: Lattice portion
- 23b: Frame edge portion
- 24, 24x, 24y, 240: Cathode
- 241, 241x: Electron injection layer
- 242: Electrically conductive layer
- 242a: First electrically conductive layer
- 242b: Second electrically conductive layer
- 243: Contact hole for cathodes
- 3: First substrate
- 31: Inorganic insulating film
- 4: Seal member
- 5: Second substrate
- 6: External terminal
- 7: Scanning line driving circuit
- 8: Data line driving circuit
- L1: Scanning line
- L2: Data line
- S1: Pixel circuit forming area
- S2: Electron injection layer forming area
- S3: Partition wall forming area
- S4: Electrically conductive layer forming area
- S4a: First electrically conductive layer forming area
- S4b: Second electrically conductive layer forming area

### MODES FOR CARRYING OUT THE INVENTION

### (Embodiment 1)

Referring to Figs., the following description will discuss an organic EL device in accordance with embodiment 1 of the present invention.

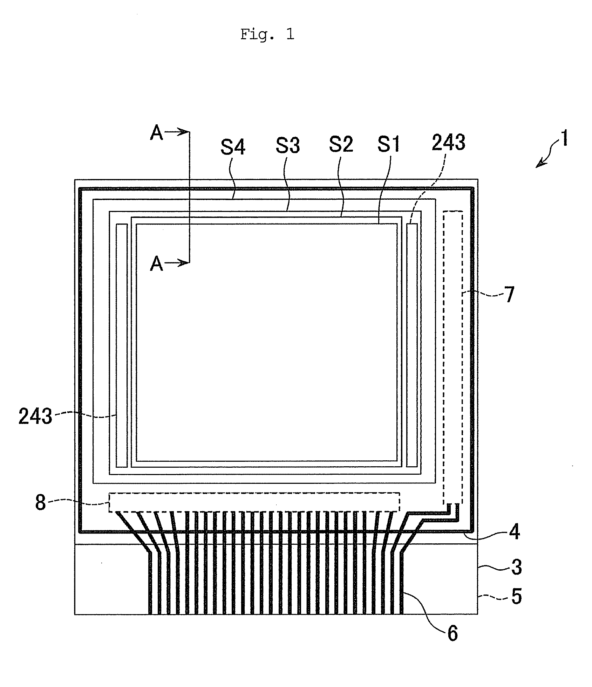

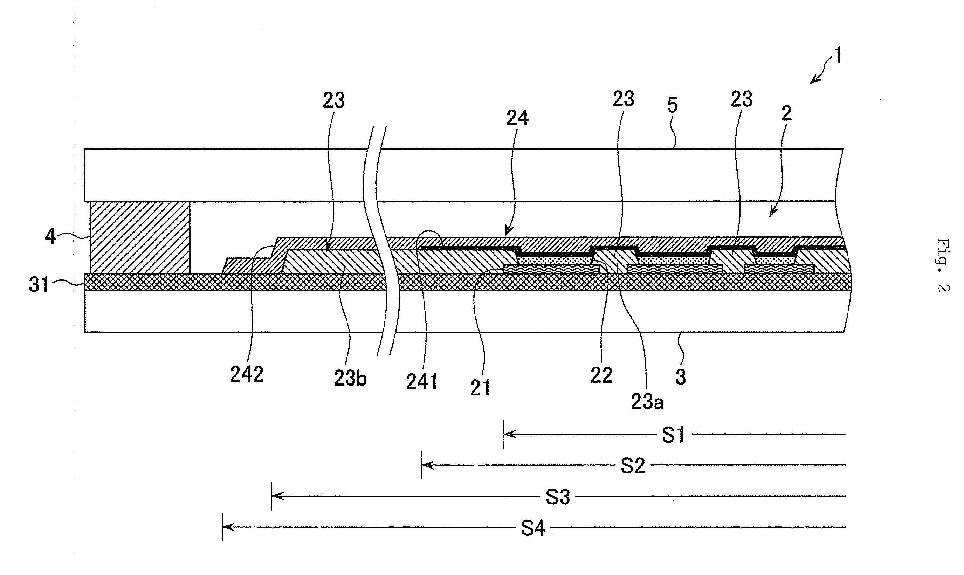

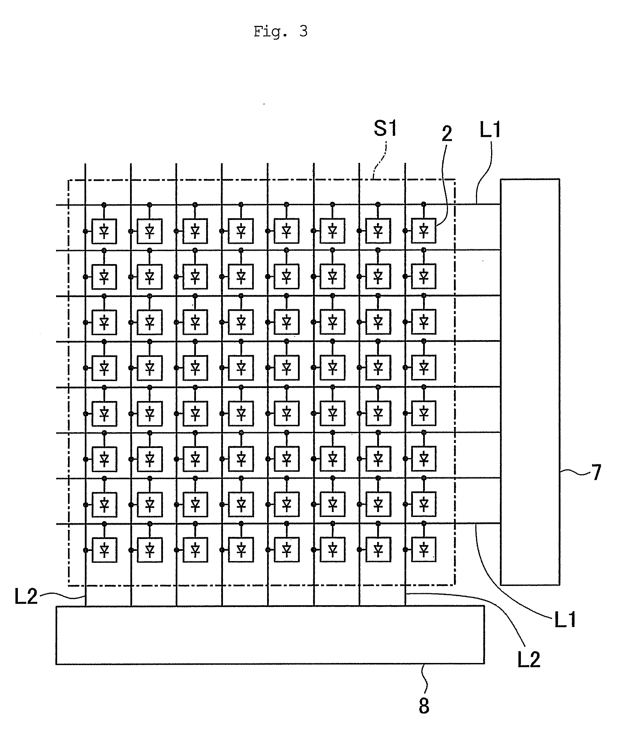

Fig. 1 shows a plan view illustrating the organic EL device in accordance with embodiment 1 of the present invention, Fig. 2 shows an A-A line cross-sectional view of the organic EL device of Fig. 1, and Fig. 3 shows a drawing that explains a circuit configuration of the organic EL device.

The organic EL device 1 is used as a light emitting apparatus. As shown in Fig. 2, in the organic EL device 1, a second substrate 5 is superimposed on a first substrate 3 serving as a support substrate on which pixel circuits 2 forming respective pixels are disposed, with a seal member 4 interpolated therebetween. As shown in Fig. 3, the pixel circuit 2 is constituted by an organic EL element that emits light as each pixel and a circuit used for driving the organic EL element, and the circuits are disposed in a dot matrix pattern arranged in longitudinal rows and lateral rows.

To one end portion of the organic EL device 1, a data line through which data is inputted to the pixel circuit 2, a scanning line that sequentially selects pixel circuits 2 to sequentially scan the display surface from one side toward the other side and a power supply line for use in supplying power to the pixel circuit 2 are attached as external terminals 6 (see Fig. 1).

As shown in Fig. 3, scanning lines L1 are placed on the respective pixel circuits 2 in the lateral direction relative to the display surface by the scanning line driving circuit 7, and data lines L2 are placed thereon in longitudinal direction relative to the display surface by the data line driving circuit 8.

These scanning line driving circuit 7 and data line driving circuit 8 are placed outside of a pixel circuit forming area S1 (see Fig. 1) having a rectangular shape serving as an image display area on which the pixel circuits 2 are formed.

As a material for forming the first substrate 3, any material may be used as long as it is chemically stable upon forming electrodes such as anodes 21 and cathodes 24 and a light emitting layer 22 (organic EL layer) thereon. Examples of the material include glass, a plastic material, a polymer film, a silicon substrate, a metal plate, and a material formed by stacking two or more kinds of these materials thereon.

As shown in Fig. 2, an inorganic insulating film 31 (for example, SiNₓ, SiO₂, etc.) may be formed on the surface of the first substrate 3 so as to flatten the surface of the first substrate 3. On the first substrate 3 on which the inorganic insulating film 31 is formed, an anode 21, a circuit (not shown in Fig. 3) for use in driving an organic EL element including a wiring layer having scanning lines and data lines, a light emitting layer 22, a partition wall 23 and a cathode 24 are stacked.

The anode 21 is disposed so as to correspond to each of pixels disposed in longitudinal rows and lateral rows. As the anode 21, a transparent electrode having a light transmitting property is preferably used. Thus, an element that emits light through the anode 21 can be obtained. As such a transparent electrode, a thin film, made of a material selected from the group consisting of a metal oxide, a metal sulfide and metal having high electric conductivity, is proposed, and preferably, those having a high light transmittance are used. The transparent electrode is selected on demand depending on the kinds of the organic layer. Specific examples of the material forming the transparent electrode include metal oxides, such as indium oxide, zinc oxide, tin oxide, indium tin oxide (ITO) and indium zinc oxide (IZO), metals such as gold, platinum, silver, copper and aluminum, and alloys containing one kind or more of these metals.

The light emitting layer 22 is disposed on the anode 21, and contains an organic substance (low-molecular weight compound and high-molecular weight compound) that emits fluorescent light or phosphorescent light. The light emitting layer 22 may further contain a dopant material. Examples of the material for forming the light emitting layer 22 include pigment-based materials, metal complex-based materials, polymer-based materials, and dopant-based materials as explained below.

Examples of the pigment-based material include: a cyclopendamine derivative, a tetraphenylbutadiene derivative compound, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a perinone derivative, a perylene derivative, an oligothiophene derivative, a trifumanyl amine derivative, an oxadiazole dimer, and a pyrazoline dimer.

Examples of the metal complex-based material include: a metal complex having a light-emitting function from a triplet excited state, such as an iridium complex, and a platinum complex; and a metal complex having an Al, a Zn, a Be, or a rare earth metal such as a Tb, an Eu, a Dy as the central metal, with an oxadiazole, a thiadiazole, a phenyl pyridine, a phenyl benzoimidazole, a quinoline structure, or the like as the ligand, such as an aluminum quinolinol complex, a benzoquinolinol beryllium complex, a benzoxazolyl zinc complex, a benzothiazole zinc complex, an azomethyl zinc complex, a porphyrin zinc complex, and an europium complex.

Examples of the polymer-based material include: a polyparaphenylene vinylene derivative, a polythiophene derivative, a polyparaphenylene derivative, a polysilane derivative, a polyacetylene derivative, a polyfluorene derivative, a polyvinyl carbazole derivative, and materials formed by polymerizing the above mentioned pigment material, and metal complex-based light emitting material.

The light emitting layer 22 may contain a dopant material so as to improve the light-emitting efficiency or change the light-emitting wavelength. Examples of the dopant material include: a perylene derivative, a coumarin derivative, a rubrene derivative, a quinacridone derivative, a squarylium derivative, a porphyrin derivative, a styryl-based pigment, a tetracene derivative, a pyrazolone derivative, decacyclene, and phenoxazone. The thickness of the light emitting layer is normally from about 2 nm to about 2000 nm.

In the organic EL element, the light emitting layer 22 is normally prepared as one layer, or may be prepared as two layers or more. The light emitting layers of two or more layers may be disposed directly in contact with one another, or a layer other than the light emitting layer may be interpolated between the layers.

Between the anode 21 and the light emitting layer 22, a hole injection layer, a hole transporting layer, an electron blocking layer, or the like may be disposed as one portion of the anode. In the case when both of the hole injection layer and the hole transporting layer are formed, the layer closer to the anode 21 is prepared as the hole injection layer, and the layer closer to the light emitting layer is prepared as the hole transporting layer. In the case when the hole injection layer or the hole transporting layer has a function for blocking the transportation of electrons, these layers may be compatibly used as the electron blocking layer.

The hole injection layer is disposed between the anode 21 and the hole transporting layer, or between the anode 21 and the light emitting layer 22. As the material for the hole injection layer for use in forming the hole injection layer, not particularly limited, known materials may be used on demand. Examples thereof include: derivatives, such as a phenylamine-based material, a starburst-type amine-based material, a phthalocyanine-based material, a hydrazone derivative, a carbazole derivative, a triazole derivative, an imidazole derivative and an oxadiazole derivative having an amino group; oxides, such as a vanadium oxide, a tantalum oxide, a tungsten oxide, a molybdenum oxide, a ruthenium oxide and an aluminum oxide; amorphous carbon, polyaniline, and a polythiophene derivative.

As the material for the hole transporting layer for use in forming the hole transporting layer, no limitation is particularly given. Examples of the hole transporting layer material include: an aromatic amine derivative, such as N,N'-diphenyl-N,N'-di(3-methylphenyl)4,4'-diaminobiphenyl (TPD) and NPB(4,4'-bis[N-(1-naphthyl)-N-phenylamino] biphenyl), polyvinylcarbazole or a derivative thereof, polysilane or a derivative thereof, a polysiloxane derivative having an aromatic amine on its side chain or main chain, a pyrazoline derivative, an arylamine derivative, a stilbene derivative, a triphenyldiamine derivative, polyaniline or its derivative, polythiophene or its derivative, polyarylamine or its derivative, polypyrrole or its derivative, poly(p-phenylenevinylene) or its derivative, and poly(2,5- thienylene vinylene) or its derivative.

The partition wall 23, which partitions the light emitting layer, is made of an insulating material. Any electrically insulating material may be used as the insulating material forming the partition wall 23. Examples of the insulating material include one or more kinds of materials selected from the group consisting of acryl, polyamide, polyimide, benzocyclobutene, siloxane polymers, and silicon oxides containing an alkyl group. The light emitting layer 22 is partitioned by a lattice portion 23a of the partition wall 23 disposed between the light emitting layers 22 and a frame edge portion 23b having a wide width that surrounds the periphery of the light emitting layers 22 disposed in a dot matrix pattern.

The cathode 24 covers the light emitting layer 22, and extends on the partition wall 23. In the present embodiment, the cathode 24 has a multilayer structure composed of two layers of the electron injection layer 241 and the electrically conductive layer 242. The cathode 24 is connected to contact holes 243 for cathodes disposed on two sides, with an electron injection layer forming area S2 on which the electron injection layer 241 is formed being sandwiched therebetween, so that it is conduction-connected to a ground line of the external terminal 6.

The electron injection layer 241 covers the light emitting layer 22 and the lattice portion 23a of the partition wall 23, and also continuously covers one portion of the frame edge portion 23b of the partition wall 23 from the light emitting layer 22. The layer thickness of the electron injection layer 241 is from 1 to 10 nm.

As the electron injection layer 241, a material capable of easily injecting electrons into the light emitting layer 22 is preferably used. The work function of a material forming the electron injection layer 241 is smaller than a work function of a material used for forming the electrically conductive layer 242, and the conductivity of the electrically conductive layer 242 is preferably made higher than the conductivity of the electron injection layer 241. Preferable examples of the material for the electron injection layer 241 of the present embodiment 1 include one kind or more materials selected from the group consisting of metals, fluorides of metals and oxides of metals (in this case, "metal" represents one kind or more metal elements selected from the group consisting of barium (Ba), calcium (Ca), lithium (Li), sodium (Na), potassium (K), magnesium (Mg), rubidium (Rb) and cesium (Cs)).

The electrically conductive layer 242 covers the entire electron injection layer 241, thereby also covering the lattice portion 23a of the partition wall 23, as well as covering the frame edge portion 23b of the partition wall 23, and extends on the first substrate 3 (inorganic insulating film 31). The electrically conductive layer 242 covers the entire partition wall 23 including the end faces of the partition wall 23. An electrically conductive layer forming area S4 on which the electrically conductive layer 242 is formed, shown in Fig. 1, is wider than the partition wall forming area S3 (see Fig. 2).

As the material forming the electrically conductive layer 242, a material capable of easily injecting electrons into the light emitting layer 22 is preferably used. Examples of the material include: metals such as aluminum (Al), scandium (Sc), vanadium (V), zinc (Zn), yttrium (Y), indium (In), cerium (Ce), samarium (Sm), europium (Eu), terbium (Tb), ytterbium (Yb), copper (Cu), and silver (Ag); alloys containing at least one kind of these metals as a main component thereof, for example, an alloy between one kind of these metals and one kind or more metals selected from the group consisting of gold (Au), platinum (Pt), manganese (Mn), titanium (Ti), cobalt (Co), nickel (Ni), tungsten (W) and tin (Sn); graphite; a graphite interlayer compound; and metal oxides, such as indium tin oxide (ITO), indium zinc oxide (IZO), and tin oxide.

In the organic EL device of the present embodiment in which light generated in the light emitting layer 22 is externally released from the anode 21 side, it is preferable to reflect the light generated in the light emitting layer 22 toward the inside on the cathode 24 side from the viewpoint of efficiency, and as the material for forming the electrically conductive layer 242, a material having a high reflectance is preferably used. Examples of preferable materials for forming the electrically conductive layer 242 include a metal selected from the group consisting of Al, Cu and Ag, or an alloy containing one kind of these metals as its main component.

In the case when the light emission is directed toward the cathode side, or toward both of the anode and cathode sides, a material having good translucency can be selected as the material for the electrically conductive layer 242, and metal oxides such as ITO, IZO and tin oxide and metal thin films can be used.

The electrically conductive layer 242 may have a multilayer structure having two or more layers. With respect to a structure using the electrically conductive layer having a multilayer structure, an explanation will be given in detail in embodiment 3 described later.

The film thickness of the electrically conductive layer 242 can be selected on demand by taking into consideration the electric conductivity and durability thereof, and the thickness is for example in a range from 10 nm to 10 µm, preferably from 20 nm to 1 µm, and more preferably from 50 nm to 500 nm. As a method for manufacturing the electrically conductive layer 242, methods, such as a vapor deposition method, a sputtering method or a laminate method for thermally contact-bonding metal thin films, are proposed.

Between the cathode 24 and the light emitting layer 22, an electron transporting layer, a hole-blocking layer, etc. may be disposed as one portion of the cathode 24. In the case when the electron injection layer 241 or the electron transporting layer has a function for blocking the transportation of hole, these layers may be compatibly used as the hole-blocking layer.

As an electron transporting material for forming the electron transporting layer, not particularly limited, known materials may be used. Examples of the electron transporting material include: an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, or 8-hydroxyquinoline or a metal complex of its derivative, polyquinoline or a derivative thereof, polyquinoxaline or a derivative thereof, and polyfluorene or a derivative thereof.

The second substrate 5 is designed to seal the respective pixel circuits 2, the scanning line driving circuit 7, the data line driving circuit 8, the wiring and the like by using the seal member 4 as a spacer member, in combination with the first substrate 3. The second substrate 5 may be made of a glass substrate, a film substrate or a metal plate.

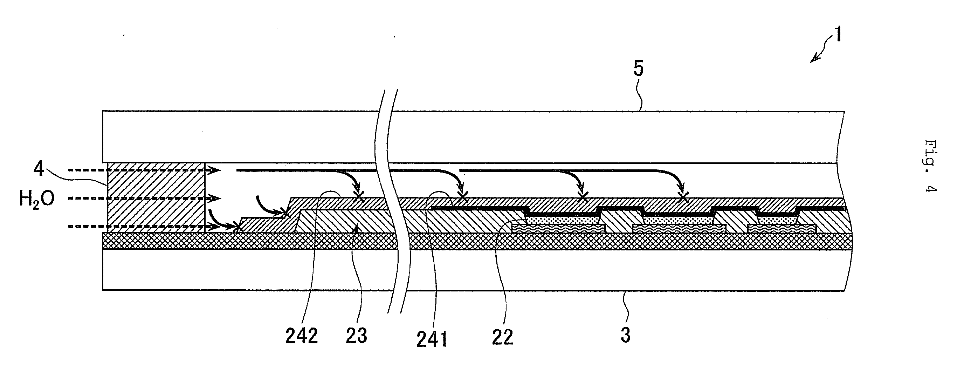

In accordance with the organic EL device 1 relating to the present embodiment 1 constructed as described above, even in the case when moisture invades into the inside thereof by permeating through the seal member 4 as shown in Fig. 4, since the light emitting layer 22 is covered with the electron injection layer 241, and since the electron injection layer 241 is covered with the electrically conductive layer 242, it is possible to prevent moisture from invading into the light emitting layer between the electron injection layer 241 and the partition wall 23 as well as between the electron injection layer 241 and the electrically conductive layer 242. Even when the partition wall 23 is made of an insulating organic material that allows moisture to permeate therethrough, since the entire partition wall 23 is covered with the electrically conductive layer 242, it is possible to prevent moisture from invading into the light emitting layer 22. Since the moisture invasion into the light emitting layer 22 is prevented by the cathode 24, the organic EL device 1 needs not to further increase the film-forming processes. Therefore, by suppressing moisture invasion into the light emitting layer 22, the organic EL device 1 makes it possible to suppress degradation of the light emitting layer and to keep quality stabilization, and also to suppress an increase in the production costs.

### (Embodiment 2)

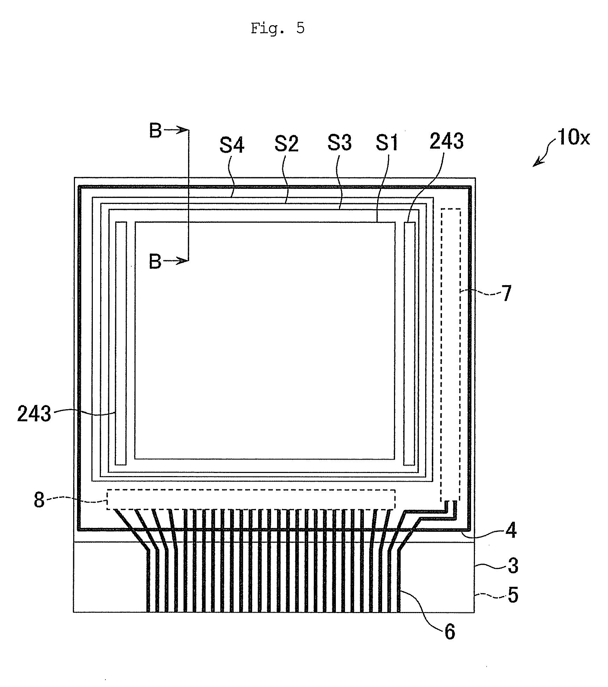

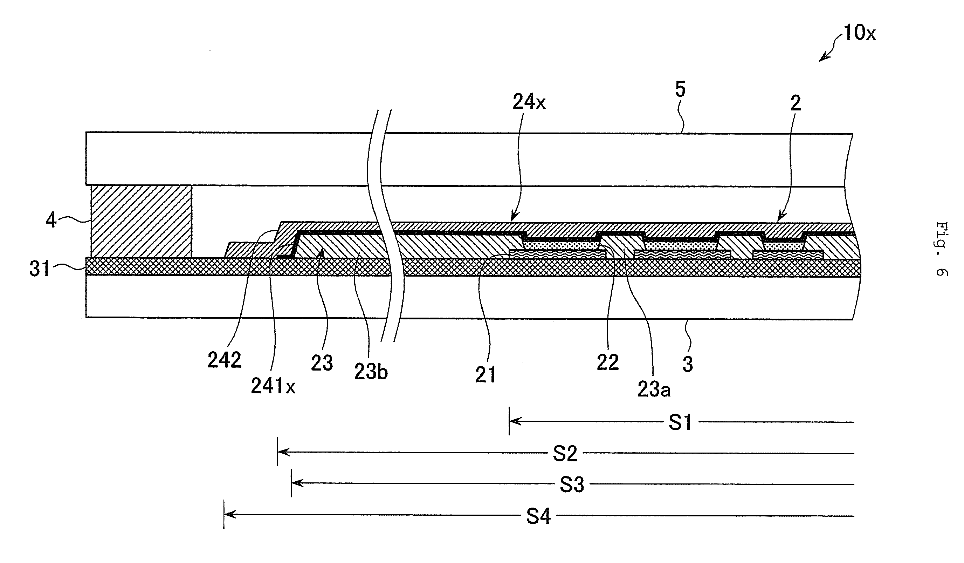

Referring to Figs., the following description will discuss an organic EL device in accordance with embodiment 2 of the present invention. In Figs. 5 and 6, those members that are the same as those of Figs.1 and 2 are indicated by the same reference numerals, and the description thereof will be omitted.

In an organic EL device in accordance with the present embodiment 2, an electron injection layer covers the entire partition wall together with the electrically conductive layer.

As shown in Figs. 5 and 6, in an organic EL device 10x, an electron injection layer 241x in a cathode 24x, which covers the light emitting layer 22, and also covers the lattice portion 23a of the partition wall 23 and the frame edge portion 23b of the partition wall 23, is allowed to extend on the first substrate 3 (inorganic insulating film 31) so that the entire partition wall 23 including the end faces of the partition wall 23 is covered. Since the electron injection layer 241x is covered with the electrically conductive layer 242, the electron injection layer 241x is not exposed. Therefore, the electron injection layer forming area S2 is wider than the partition wall forming area S3.

The electron injection layer 241x may be made of the same material with the same thickness as those of the electron injection layer 241 of embodiment 1.

By forming the electron injection layer 241x in this manner, it is possible not only to obtain the same effects as those of embodiment 1, but also to suppress moisture invasion into the light emitting layer 22, even when the electron injection layer 241x is formed into a thin film.

### (Embodiment 3)

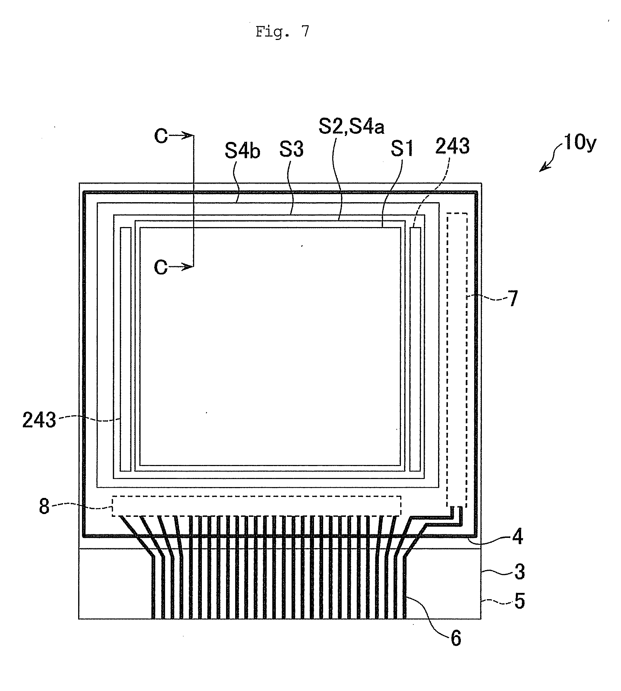

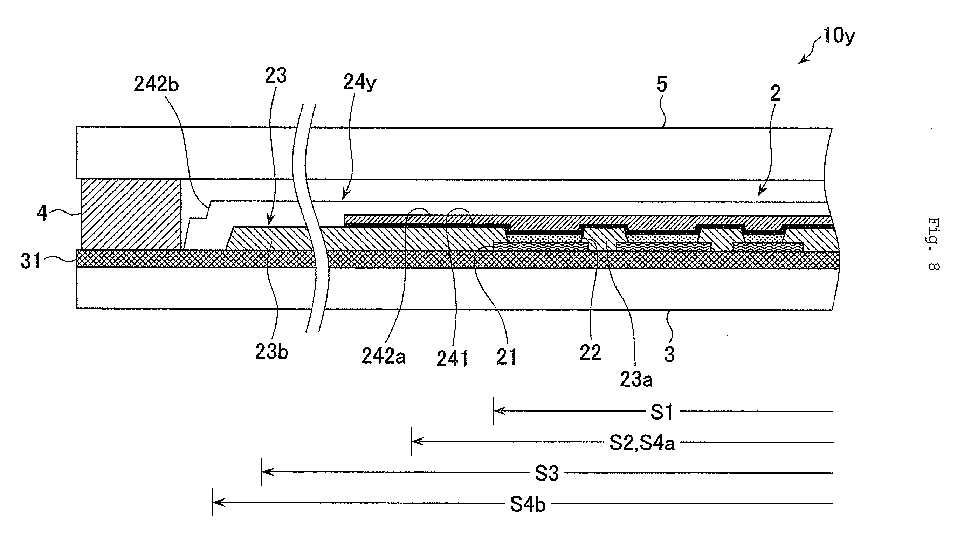

Referring to Figs., the following description will discuss an organic EL device in accordance with embodiment 3 of the present invention. In Figs. 7 and 8, those members that are the same as those of Figs. 1 and 2 as well as Figs. 5 and 6 are indicated by the same reference numerals, and the description thereof will be omitted.

In an organic EL device in accordance with the present embodiment 3, an electrically conductive layer is configured by a plurality of layers.

As shown in Figs. 7 and 8, in an organic EL device 10y, a cathode 24y has an electron injection layer 241, and also has an electrically conductive layer 242 configured by two layers of a first electrically conductive layer 242a and a second electrically conductive layer 242b.

The first electrically conductive layer 242a is disposed on the electron injection layer 241, and formed into the same pattern as that of the electron injection layer 241. The first electrically conductive layer 242a and the electron injection layer 241 are designed such that the ends thereof are disposed at the same positions. In the same manner as in the electron injection layer 241 of embodiment 1, the first electrically conductive layer 242a covers the light emitting layer 22 and the lattice portion 23a of the partition wall 23, and also continuously covers one portion of the frame edge portion 23b from the light emitting layer 22. As shown in Fig. 8, a first electrically conductive layer forming area S4a is the same as the electron injection layer forming area S2.

From the viewpoint that the first electrically conductive layer 242a is made in contact with the electron injection layer 241, as a material for the first electrically conductive layer 242a, those materials forming the electrically conductive layer 242 shown in embodiment 1 can be used. Examples of preferable materials for forming the first electrically conductive layer 242a include a metal selected from the group consisting of Al, Cu and Ag, or an alloy containing one kind of these metals as its main component, or indium tin oxide (ITO) or indium zinc oxide (IZO), and more preferably, from the viewpoints of high electrical conductivity and low material costs, aluminum or an alloy containing aluminum as its main component is used. The work function of a material for the first electrically conductive layer 242a is preferably greater than a work function of a material used for forming the electron injection layer 241. In the case of an organic EL device of a type that emits light from the anode 21 side, a material having a high reflectance in a visible light region is desirably selected as the material for forming the first electrically conductive layer 242a, and in terms of this point, the material for forming the first electrically conductive layer 242a is preferably a metal selected from the group consisting of aluminum, silver and copper, or an alloy containing one kind of these as its main component.

In the present embodiment 3, the layer thickness of the first electrically conductive layer 242a is preferably from 10 to 500 nm in its thinnest portion.

The second electrically conductive layer 242b is disposed on the first electrically conductive layer 242a and the partition wall 23. More specifically, the second electrically conductive layer 242b covers the first electrically conductive layer 242a, and extends from the frame edge portion 23b of the partition wall 23 where none of the electron injection layer 241 and the first electrically conductive layer 242a are located onto the first substrate 3 (inorganic insulating film 31) so that all the partition wall 23 including the end faces of the partition wall 23 is covered therewith.

As shown in Fig. 8, the second electrically conductive layer forming area S4b is wider than the partition wall forming area S3.

The second electrically conductive layer 242b is not directly made in contact with the electron injection layer 241 except for the end face portion thereof; therefore, as a material for forming the second electrically conductive layer 242b, a material having a high electrical conductivity may be selected on demand, and used. Examples of preferable materials for forming the second electrically conductive layer 242b include a metal selected from the group consisting of Al, Cu and Ag, or an alloy containing one kind of these metals as its main component, or indium tin oxide (ITO) or indium zinc oxide (IZO), and more preferably, Ag or an alloy containing Ag as its main component is used.

In the present embodiment 3, the layer thickness of the second electrically conductive layer 242b is preferably from 50 to 1000 nm in its thinnest portion.

In the organic EL device 10y of the present embodiment 3, since the second electrically conductive layer 242b covers the entire partition wall 23, the same effects as those of embodiment 1 can be obtained. In addition, since the electrically conductive layer 242 has a two-layer structure including the first electrically conductive layer 242a disposed on the electron injection layer 241 and the second electrically conductive layer 242b that is disposed on the first electrically conductive layer 242a and covers the first electrically conductive layer 242a, the following advantages are achieved in terms of production. For example, the following methods are proposed for film-forming the cathode 24 of the organic EL device in accordance with the present embodiment 2: (1)a method in which by using a single film-forming chamber, an electron injection layer and an electrically conductive layer 242 are respectively stacked while exchanging masks from a mask for an electron injection layer to a mask for an electrically conductive layer, (2) a method in which by using two film-forming chambers, after an electron injection layer has been film-formed in the first chamber, the resulting substrate is transported into the second chamber, and an electrically conductive layer 242 is film-formed and stacked thereon. From the viewpoint of continuous productivity for the organic EL element, since the method (1) requires mask exchanges for each substrate, it is difficult to carry out continuous producing processes; therefore, the method (2) is preferably selected. However, upon transporting a substrate into the second chamber, the electron injection layer might be damaged due to moisture and oxygen. In contrast, in the present embodiment 3, in accordance with the method (2), an electron injection layer is film-formed in the first chamber, and after swiftly film-forming a first electrically conductive layer 242a by continuously using the same mask, as it is, the resulting substrate is transported into the second chamber, and a second electrically conductive layer 242b is film-formed thereon; thus, the aforementioned damage can be reduced. Since the end faces of the electron injection layer 241 are covered with the second electrically conductive layer 242b, it is possible to prevent layer separation from its own end faces of the electron injection layer 241 due to oxidization.

Since the first electrically conductive layer 242a and the second electrically conductive layer 242b are respectively made of a first electrically conductive material and a second electrically conductive material different from the first electrically conductive material, the range of selection of electrically conductive materials is widened. As the first electrically conductive material for forming the first electrically conductive layer 242a, an electrically conductive material such as Al and Ag that can be formed into a film by using a film forming method that hardly gives damages to the light emitting layer, such as a low resistivity heating vapor deposition method, a cell heating vapor deposition method and an electron-beam vapor deposition method, may be selected. As the second electrically conductive material for forming the second electrically conductive layer 242b, an electrically conductive material, such as Al, Ag, Cu, ITO, and IZO that can be formed into a film by using a method capable of accelerating a film-forming rate, such as an electron beam vapor deposition method, a high-frequency inductive heating vapor deposition method, a sputtering method and an ion plating method, may be selected. With this arrangement, it is possible to accelerate the processing speed of the entire cathode-forming processes while suppressing degradation of characteristics of the light emitting layer 22. As a material for forming the second electrically conductive layer 242b, from the viewpoint of selecting a material having good adhesion to the frame edge portion 23b, electrically conductive materials, such as Al, Ag and Cu, may be selected.

As described earlier, by forming the electron injection layer 241 and the first electrically conductive layer 242a so as to have the same pattern, upon forming the electron injection layer 241 and the first electrically conductive layer 242a by a vacuum vapor deposition method, these layers can be formed using the same mask. Thus, it becomes possible to easily form the electron injection layer 241 and the first electrically conductive layer 242a.

In the present embodiment 3, the first electrically conductive layer 242a and the second electrically conductive layer 242b are made of mutually different electrically conductive materials; however, these layers may be made of the same material. In the case when the first electrically conductive layer 242a and the second electrically conductive layer 242b are made of the same electrically conductive material, an electrically conductive layer 24y has an area composed of only the second electrically conductive layer 242b and an area composed of the first electrically conductive layer 242a and the second electrically conductive layer 242b, that is, areas being different in film thickness from each other are prepared. With this arrangement, the presences of the first electrically conductive layer 242a and the second electrically conductive layer 242b can be confirmed.

Although the foregoing description has discussed the embodiments of the present invention, the present invention is not intended to be limited by the embodiments. For example, in the embodiments 1 to 3, the electrically conductive layer 242 is formed so as to cover the entire partition wall 23; however, when the electrically conductive layer 242 covers at least the electron injection layer, it is possible to suppress invasion of moisture between the electrically conductive layer and the electron injection layer as well as between the electron injection layer and the partition wall.

### INDUSTRIAL APPLICABILITY

In accordance with the present invention, by effectively suppressing moisture invasion into a light emitting layer in an organic EL device, it is possible to suppress degradation of the light emitting layer, to stabilize the quality of the organic EL device and consequently to suppress an increase in the production costs of the organic EL device. The present invention is desirably applied to an organic EL device provided with organic EL elements, and the resultant organic EL device may be used for both of an active-matrix type system and a passive-matrix type system. The organic EL device of the present invention may be used, for example, for a display apparatus and an illumination apparatus in which the organic EL elements need to be sealed.

## Claims

1. An organic EL device comprising
a first substrate,
an anode that is located on the first substrate,
a light emitting layer that is located on the anode,
a partition wall that is formed of an insulating material and partitions the light emitting layer,
a cathode that covers the light emitting layer and extends on the partition wall, and
a second substrate that is superimposed to the first substrate via a seal member,
wherein
the cathode has a multilayer structure comprising an electron injection layer that injects electrons to the light emitting layer, and at least one electrically conductive layer,
the electron injection layer covers the light emitting layer,
and
at least one electrically conductive layer covers the electron injection layer.

2. The organic EL device according to Claim 1, wherein the electrically conductive layer covers the partition wall.

3. The organic EL device according to Claim 2, wherein the electron injection layer covers the partition wall.

4. The organic EL device according to any one of Claims 1 to 3, wherein the electrically conductive layer is composed of a first electrically conductive layer that is located on the electron injection layer and a second electrically conductive layer that covers the first electrically conductive layer.

5. The organic EL device according to Claim 4, wherein the second electrically conductive layer covers the partition wall.

6. The organic EL device according to Claim 4 or 5, wherein the first electrically conductive layer and the second electrically conductive layer are respectively composed of a first electrically conductive material and a second electrically conductive material that is different from the first electrically conductive material.

7. The organic EL device according to Claim 4 or 5, wherein the first electrically conductive material is a metal selected from the group consisting of Al, Cu and Ag, or an alloy comprising one kind of these metals as a main component, or indium tin oxide, or indium zinc oxide.

8. The organic EL device according to Claim 4 or 5, wherein the second electrically conductive material is a metal selected from the group consisting of Al, Cu and Ag, or an alloy comprising one kind of these metals as a main component, or indium tin oxide, or indium zinc oxide.

9. The organic EL device according to any one of Claims 4 to 6, wherein the electron injection layer and the first electrically conductive layer are in the same pattern.
